(19) Europäisches Patentamt / European Patent Office / Office européen des brevets

(11) **EP 3 110 746 B1**

(12) **EUROPÄISCHE PATENTSCHRIFT**

(45) Veröffentlichungstag und Bekanntmachung des Hinweises auf die Patenterteilung:
**03.07.2019 Patentblatt 2019/27**

(21) Anmeldenummer: **15704463.7**

(22) Anmeldetag: **11.02.2015**

(51) Int Cl.:
*B81B 3/00* (2006.01)     *G01C 19/5719* (2012.01)

(86) Internationale Anmeldenummer:
**PCT/EP2015/000303**

(87) Internationale Veröffentlichungsnummer:
**WO 2015/128062 (03.09.2015 Gazette 2015/35)**

(54) **MIKROMECHANISCHES BAUTEIL MIT GETEILTER, GALVANISCH ISOLIERTER AKTIVER STRUKTUR UND VERFAHREN ZUM BETREIBEN EINES SOLCHEN BAUTEILS**

MICROMECHANICAL COMPONENT HAVING A SPLIT, GALVANICALLY ISOLATED ACTIVE STRUCTURE, AND METHOD FOR OPERATING SUCH A COMPONENT

COMPOSANT MICROMÉCANIQUE COMPORTANT UNE STRUCTURE ACTIVE SÉPARÉE À ISOLATION GALVANIQUE ET PROCÉDÉ DE FONCTIONNEMENT D'UN TEL COMPOSANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.02.2014 DE 102014002823**

(43) Veröffentlichungstag der Anmeldung:
**04.01.2017 Patentblatt 2017/01**

(73) Patentinhaber: **Northrop Grumman LITEF GmbH 79115 Freiburg (DE)**

(72) Erfinder: **SPAHLINGER, Günter 70188 Stuttgart (DE)**

(74) Vertreter: **Müller Hoffmann & Partner Patentanwälte mbB St.-Martin-Strasse 58 81541 München (DE)**

(56) Entgegenhaltungen:
US-A- 6 067 858     US-A- 6 078 016
US-A1- 2010 117 166     US-A1- 2010 134 860
US-B1- 6 291 875

**Beschreibung**

Die Erfindung bezieht sich auf ein Bauteil, insbesondere ein mikromechanisches, mikro-elektromechanisches (MEMS) bzw. mikro-opto-elektromechanisches (MOEMS) Bauteil, das eine geteilte, galvanisch isolierte aktive Struktur aufweist.

Mikro-elektromechanische Bauteile (MEMS) bzw. mikro-opto-elektromechanische Bauteile (MOEMS) umfassen häufig aktive Strukturen. Unter "aktiver Struktur" sind hier insbesondere bewegliche Strukturen oder Strukturen, die gleichermaßen bewegliche und optische Komponenten aufweisen (z.B. bewegliche Spiegel) zu verstehen. Der Begriff "aktives Gebiet" bezeichnet das Gebiet bzw. Volumen des Bauteils, in dem die aktive Struktur liegt bzw. sich bewegt.

Bei mikromechanischen Sensoren wie Beschleunigungsmessern und Kreiseln, die auf der Funktion eines mechanischen Schwingers, das heißt auf der Bewegung einer aktiven Struktur, beruhen, können sowohl der Antrieb des Schwingers als auch die Detektion der Auslenkung des Schwingers über bewegliche Elektroden an der aktiven Struktur und feste Elektroden des Bauteils realisiert werden. Dafür gibt es im Wesentlichen zwei Möglichkeiten: Bei einem Gleichstromverfahren (DC-Verfahren) liegt die bewegliche Struktur an Masse. Für die Antriebs- und Detektionsfunktionen werden getrennte Elektroden verwendet, wobei die Antriebsfunktion die quadratische Abhängigkeit der Antriebskraft von den angelegten Spannungen berücksichtigen muss. Die Detektionsfunktion beruht entweder auf einer Messung von Ladungsverschiebungen auf mit Gleichspannung vorgespannten Elektroden oder auf einer Messung der Kapazitäten der Detektionselektroden. Im ersten Fall läßt sich aufgrund von Ladungsdriften bei der Frequenz Null, die beispielsweise bei einer konstanten Beschleunigung in Beschleunigungsmessern gegeben ist, keine Detektion durchführen, im zweiten Fall werden störende Kapazitäten mitgemessen, was die erreichbare Genauigkeit reduziert.

Bei einem Trägerfrequenzverfahren liegt die bewegliche Struktur am Eingang eines Ladungsverstärkers und damit an virtueller Masse. Der Ladungsverstärker stellt das Detektionssignal bereit. Für Antrieb und Detektion werden dieselben Elektroden benutzt, wobei Antrieb und Detektion separat realisiert werden, beispielsweise durch Zeitmultiplex in zwei Phasen. In der Antriebsphase wird eine Gleichspannung angelegt, während in der Detektionsphase eine Spannung mit einer Trägerfrequenz an den Elektroden angelegt wird. Die Trägerfrequenz kann im einfachsten Fall einen definierten Spannungssprung beinhalten und bewirkt an der beweglichen Elektrode eine auslenkungsabhängige Ladungsverschiebung, die dann durch den Ladungsverstärker detektiert wird. Dabei können sich störende Wechselwirkungen zwischen Antrieb und Detektion ergeben. Bei Sensoren mit mehreren Freiheitsgraden, zum Beispiel Kreisel oder Sensoren mit Doppelschwingern, kann es notwendig sein, ein kompliziertes Zeitmultiplexverfahren anzuwenden, um eine Trennung der einzelnen Detektionssignale zu ermöglichen.

Die US 2010/134860 A1 offenbart ein mikroelektromechanisches System mit einer feststehende Elektrode, die eine erste Elektrodengruppe beinhaltet und einer bewegliche Elektrode, die in Bezug auf die feste Elektrode bewegt wird, wenn eine Spannung angelegt wird, und die eine zweite Elektrodengruppe enthält, die der ersten Elektrodengruppe gegenüberliegt. Ferner sind die Elektroden von mindestens einer der ersten Elektrodengruppe und der zweiten Elektrodengruppe über einen Widerstand verbunden.

Die US 6 078 016 A offenbart einen Halbleiterbeschleunigungsschalter mit einem feststehenden Abschnitt, der eine erste Steuerelektrode aufweist, und einem beweglichen Abschnitt, der einen beweglichen Körper aufweist. Durch Anlegen einer Spannung zwischen der ersten Steuerelektrode und einer Elektrode, die auf dem beweglichen Körper angeordnet ist, wird der beweglichen Körpers durch die elektrostatische Anziehung in einer Ausgangsposition gehalten. Der bewegliche Körper wird verschoben, wenn eine genügend große Beschleunigung auf den Schalter wirkt. Der Schwellenwert der zu erfassenden Beschleunigung und weitere Eigenschaften des Beschleunigungsmessers Schalter können leicht eingestellt werden.

Die US 2010/117166 A1 offenbart ein Verfahren zur Herstellung eines Bauteils, insbesondere einer mikromechanischen, mikro-elektromechanischen oder mikro-opto-elektromechanische Komponente und einer solchen Komponente, die eine aktive Struktur, die in einer Schichtstruktur eingebettet ist, aufweist. Leiterbahnbrücken werden durch Ätzen von ersten und zweiten Vertiefungen mit ersten und zweiten, unterschiedlichen Ätztiefen in einer Deckschicht aus einer ersten Schichtkombination ausgebildet, die zusätzlich ein Substrat und eine Isolationsschicht umfasst. Die tiefere Vertiefung wird zur Isolierung der Leiterbahn-Brücke benutzt, während die flachere Vertiefung Raum für die aktive Struktur bietet, wobei der Raum durch die Leiterbahnbrücke überbrückt wird.

Die US 6 067 858 A offenbart Mikro-Kreisel, die geeignet sind eine Drehung um eine Achse parallel zu der Oberfläche eines Substrats zu messen. Eine Spannungsdifferenz zwischen Paaren von Elektrodenfingern kann benutzt werden um den Quadraturfehler zu reduzieren. Der Mikro-Kreisel umfasst eine Vibrationsstruktur und ineinandergreifenden Elektroden mit einem hohen Seitenverhältnis.

Die US 6 291 875 B1 offenbart eine Vorrichtung mit einem Substrat, das geätzt wird, um mechanische Strukturen zu definieren, von denen zumindest einige seitlich mit einem Rest des Substrats verbunden sind. Elektrische Isolierung an den Punkten, wo die mechanischen Strukturen an dem Substrat befestigt sind, ist durch gefüllte Isolationsgräben vorgesehen. Gefüllten Gräben können auch Strukturelemente an Stellen voneinander elektrisch isolieren, an denen eine mechanische Befestigung von Strukturelementen gewünscht wird. Die Leistung der mikroelektromechanischen Vorrichtungen wird um verbessert durch 1) ein hohes Aspektverhältnis zwischen den vertikalen und seitlichen Abmessungen der mechanischen Elemente, 2) die Integration von Elektronik auf dem gleichen Substrat auf dem auch die mechanischen Elemente angeordnet sind, 3) eine gute elektrische Isolation zwischen den mechanischen Elementen und Schaltungen.

Es ist daher die Aufgabe der Erfindung, ein mikromechanisches Bauteil, das die genannten Nachteile der möglichen Antriebs- und Detektionsverfahren behebt, sowie ein Verfahren zum Betreiben eines solchen Bauteils bereitzustellen. Darüber hinaus ist es Aufgabe der Erfindung, ein Bauteil beziehungsweise ein Verfahren bereitzustellen, bei dem eine selbstmischende Funktion bei Antrieb und Detektion auf die Arbeitsfrequenz des Bauteils realisiert werden kann.

Die Aufgabe wird gelöst durch den Gegenstand der unabhängigen Patentansprüche. Bevorzugte Ausführungsformen finden sich in den Unteransprüchen.

Ausführungsformen des erfindungsgemäßen Bauteils und des erfindungsgemäßen Verfahrens werden im Folgenden anhand der Figuren näher erläutert, wobei gleichartige Elemente mit gleichen Bezugszeichen gekennzeichnet sind. Darüber hinaus können Elemente der dargestellten Ausführungsformen auch beliebig miteinander kombiniert werden, solange nichts Gegenteiliges erwähnt ist.

Die Figur 1A zeigt ein Bauteil gemäß einer Ausführungsform in einem Querschnitt.

Die Figur 1B zeigt eine Draufsicht auf die Strukturschicht des Bauteils aus Figur 1A.

Die Figur 2 zeigt eine aktive Struktur und dazugehörige feste Elektroden einer ersten Ausführungsform des Bauteils in einer Draufsicht.

Die Figur 3 zeigt schematisch die Elektrodenanordnung und elektrische Belegung der Elektroden der ersten Ausführungsform des erfindungsgemäßen Bauteils.

Die Figur 4 zeigt eine beispielhafte Ausgestaltung der Elektroden der ersten Ausführungsform als eintauchende Kammelektroden.

Die Figur 5 zeigt schematisch die Elektrodenanordnung und elektrische Belegung der Elektroden einer zweiten Ausführungsform des erfindungsgemäßen Bauteils.

Die Figur 6 zeigt schematisch die Elektrodenanordnung und elektrische Belegung der Elektroden einer dritten Ausführungsform des erfindungsgemäßen Bauteils.

Die Figur 7 zeigt schematisch die Elektrodenanordnung und elektrische Belegung der Elektroden einer vierten Ausführungsform des erfindungsgemäßen Bauteils.

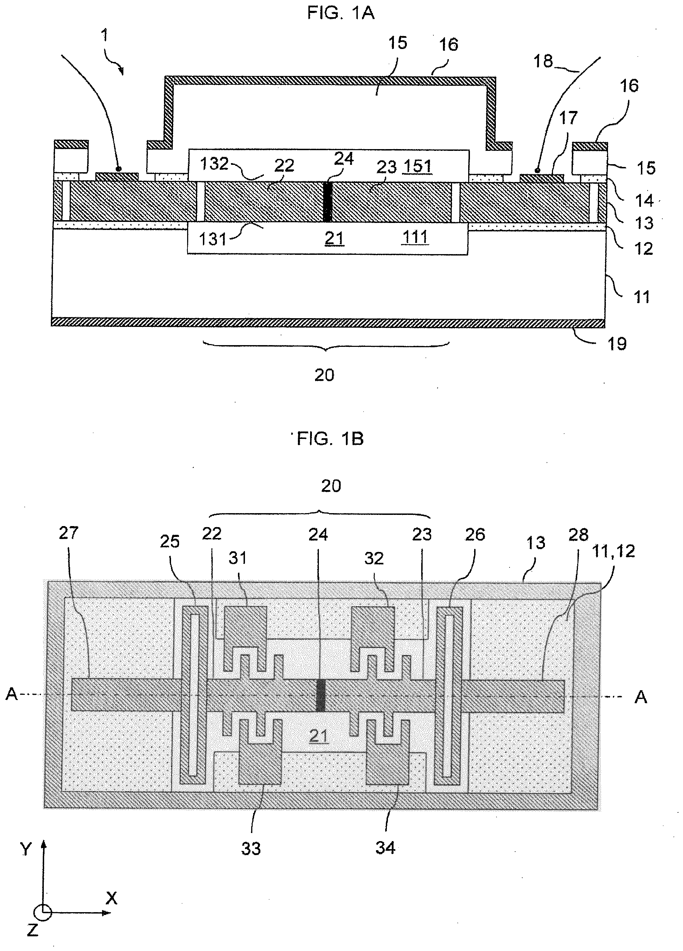

Figur 1 zeigt einen Querschnitt durch ein erfindungsgemäßes Bauteil 1 gemäß einer Ausführungsform. Das Bauteil 1 umfasst ein erstes Substrat 11, eine erste Isolationsschicht 12, eine Strukturschicht 13, eine zweite Isolationsschicht 14 sowie ein zweites Substrat 15. Darüber hinaus kann das Bauteil 1 eine erste Deckschicht 16, eine Kontaktfläche 17, die auf der Strukturschicht 13 aufgebracht ist, einen mit der Kontaktfläche 17 verbundenen Kontakt 18 sowie eine zweite Deckschicht 19 aufweisen.

Der Begriff "Substrat" beschreibt Gebilde, die nur aus einem Material bestehen, beispielsweise einen Siliziumwafer oder eine Glasscheibe, die aber auch einen Verbund aus mehreren Schichten und Materialien beinhalten können. Demzufolge können das erste Substrat 11 und/oder das zweite Substrat 15 vollständig elektrisch leitfähig sein, nur in Bereichen elektrisch leitfähig sein oder aus einem elektrisch isolierenden Material oder elektrisch isolierenden Materialien bestehen. Für den Fall dass das erste Substrat 11 aus einem elektrisch isolierenden Material besteht kann die erste Isolationsschicht 12 auch nicht vorhanden sein. Gleichfalls kann die zweite Isolationsschicht 14 eingespart werden, wenn das zweite Substrat 15 aus einem elektrisch nicht leitenden Material besteht.

Auch der Begriff "Strukturschicht" beschreibt Gebilde, die nur aus einem Material bestehen, beispielsweise einer Siliziumschicht, die aber auch einen Verbund aus mehreren Schichten und Materialien beinhalten können, solange zumindest ein Bereich der Strukturschicht 13 elektrisch leitfähig ist. Die elektrisch leitfähigen Bereiche der Strukturschicht 13 ermöglichen das Anlegen oder Auslesen elektrischer Potenziale an vorgegebenen Bereichen der Strukturschicht 13. Vorzugsweise ist die Strukturschicht 13 vollständig elektrisch leitfähig.

Die erste Deckschicht 16, die auf der der Strukturschicht 13 abgewandten Oberfläche des zweiten Substrates 15 angeordnet ist, sowie die zweite Deckschicht 19 die auf der der Strukturschicht 13 abgewandten Oberfläche des ersten Substrates 11 angeordnet ist, können aus dem selben Material, beispielsweise einem Metall, oder aus unterschiedlichen Materialien bestehen. Sie können der Abschirmung eines aktiven Gebietes des Bauteils 1 vor äußeren elektrischen Feldern oder anderen Umwelteinflüssen, wie beispielsweise Feuchtigkeit, dienen. Darüber hinaus können sie zur Bereitstellung eines definierten elektrischen Potenzials am ersten Substrat 11 beziehungsweise am zweiten Substrat 15 dienen. Jedoch sind die erste Deckschicht 16 und die zweite Deckschicht 19 optional.

Die erste Kontaktfläche 17 besteht aus einem leitfähigen Material und dient dem Bereitstellen oder Auslesen (Detektieren) eines elektrischen Potenzials an einem bestimmten Bereich der Strukturschicht 13. Die Kontaktfläche 17 kann mittels eines Drahtes 18, wie in Figur 1A dargestellt, kontaktiert werden, jedoch sind auch andere Verfahren zur Herstellung eines elektrischen Kontaktes möglich.

In der Strukturschicht 13 ist eine aktive Struktur 20 ausgebildet, die sich in einem aktiven Gebiet 21 in mindestens eine Richtung bewegen kann. Das aktive Gebiet 21 wird beispielsweise durch eine erste Vertiefung 111, die in einer der Strukturschicht zugewandten Oberfläche des ersten Substrates 11 ausgebildet ist, sowie eine zweite Vertiefung 151, die in einer der Strukturschicht 13 zugewandten Oberfläche des zweiten Substrates 15 ausgebildet ist, realisiert. Die aktive Struktur 20 umfasst mindestens einen ersten Bereich 22 und einen zweiten Bereich 23, die jeweils elektrisch leitfähig sind, und entlang einer ersten Achse physisch starr miteinander verbunden sind. Der erste Bereich 22 und der zweite Bereich 23 sind dabei durch einen isolierenden Bereich 24 elektrisch voneinander isoliert. Der isolierende Bereich 24 erstreckt sich dabei über die gesamte Tiefe der Strukturschicht 13, das heißt er erstreckt sich von einer ersten Oberfläche 131 der Strukturschicht 13 durchgängig bis zu einer zweiten Oberfläche 132 der Strukturschicht 13. Die erste Oberfläche 131 ist dabei dem ersten Substrat 11 zugewandt, während die zweite Oberfläche 132 dem zweiten Substrat 15 zugewandt ist. Der isolierende Bereich 24 kann beispielsweise durch ein isolierendes Material realisiert sein und kann sowohl in der Draufsicht als auch im Querschnitt beliebig angeordnet sein und beliebige Formen aufweisen. Das heißt, der isolierende Bereich 24 kann in der Draufsicht beispielsweise geradlinig oder gekrümmt verlaufen und sich im Querschnitt senkrecht zur ersten Oberfläche 131 und zur zweiten Oberfläche 132 oder in einem definierten Winkel zu diesen Oberflächen, geradlinig oder gekrümmt verlaufen. Darüber hinaus kann ebenfalls die Breite des isolierenden Bereiches 24 im Querschnitt variieren, solange eine vollständige elektrische Isolation des ersten Bereiches 22 vom zweiten Bereich 23 der Strukturschicht 13 gewährleistet ist.

In Figur 1B ist eine Draufsicht auf die Strukturschicht des Bauteils 1 aus Figur 1A gezeigt, wobei die in Figur 1A dargestellte Schnittebene durch die Linie A-A gekennzeichnet ist. Wie in Figur 1B zu sehen ist erstreckt sich die Schnittebene A-A entlang einer ersten Achse des Bauteils 1, die der X-Achse entspricht. In Figur 1B sind die Strukturschicht 13 sowie darunter liegende Bereiche des ersten Substrates 11 und der ersten Isolationsschicht 12 dargestellt. Die aktive Struktur 20 ist mittels Federn 25 und 26 mit Kontaktbereichen 27 und 28 der Strukturschicht 13 verbunden, wobei die Kontaktbereiche 27 und 28 fest mit dem ersten Substrat 11 und zumindest in Bereichen auch fest mit dem zweiten Substrat 15 verbunden sind. Der erste Bereich 22 der aktiven Struktur 20 ist über die erste Feder 25 mit dem ersten Kontaktbereich 27 der Strukturschicht 13 verbunden, während der zweite Bereich 23 der aktiven Struktur 20 über die zweite Feder 26 mit dem zweiten Kontaktbereich 28 der Strukturschicht 13 verbunden ist. Die erste Feder 25 und die zweite Feder 26 erlauben eine Bewegung der aktiven Struktur 20 zumindest entlang der ersten Achse, das heißt in X-Richtung, wobei jedoch auch eine Bewegung der aktiven Struktur 20 entlang einer zweiten Achse und/oder entlang einer dritten Achse in einem dreidimensionalen Raum, zum Beispiel in Y-Richtung oder in Z-Richtung, möglich ist. Dabei können die einzelnen Achsen jeweils senkrecht zueinander stehen oder auch andere Winkel zueinander aufweisen. Das Bauteil 1 weist darüber hinaus noch weitere Elektroden 31, 32, 33 und 34 auf, die starr mit dem ersten Substrat 11 und/oder dem zweiten Substrat 15 verbunden sind und als Anregungs-, Auslese- oder Rückstellelektroden dienen. Sie sind so angeordnet, dass sie in das aktive Gebiet 21 des Bauteiles 1 hineinragen und mit bestimmten Bereichen der aktiven Struktur 20, die nachfolgend näher erläutert werden, Kapazitäten bilden.

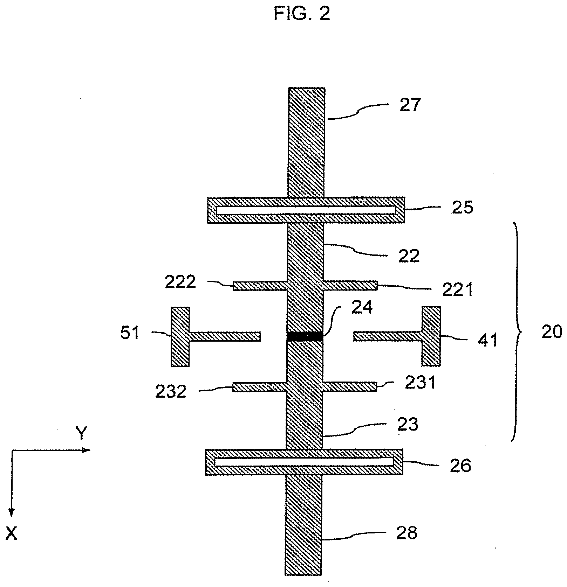

Figur 2 zeigt eine aktive Struktur und dazugehörige feste Elektroden einer ersten Ausführungsform des Bauteils in einer Draufsicht, wobei zum besseren Verständnis neben der aktiven Struktur 20 auch die erste Feder 25 und die zweite Feder 26 sowie der erste Kontaktbereich 27 und der zweite Kontaktbereich 28, wie sie in Figur 1B dargestellt waren, gezeigt sind. Jedoch ist die Darstellung der aktiven Struktur 20 und der mit ihr verbundenen Bereiche der Strukturschicht 13 um 90° bezüglich der Darstellung in Figur 1B gedreht. Gemäß der ersten Ausführungsform des erfindungsgemäßen Bauteils umfasst die aktive Struktur 20 den ersten Bereich 22 und den zweiten Bereich 23, die durch den isolierenden Bereich 24 elektrisch voneinander isoliert sind. Darüber hinaus umfasst die aktive Struktur 20 eine erste Elektrode 221, eine zweite Elektrode 222, eine dritte Elektrode 231 und eine vierte Elektrode 232. Die erste Elektrode 221 ist im ersten Bereich 22 angeordnet und erstreckt sich von diesem aus in eine erste Richtung entlang der zweiten Achse, das heißt der Y-Achse. Die zweite Elektrode 222 ist ebenfalls im ersten Bereich 22 angeordnet, erstreckt sich jedoch von diesem aus in eine zweite Richtung entlang der zweiten Achse. Die zweite Richtung verläuft dabei entgegengesetzt zur ersten Richtung. Die zweite Achse, das heißt die Y-Achse, steht senkrecht zur ersten Achse, das heißt zur X-Achse. Die dritte Elektrode 231 und die vierte Elektrode 232 sind im zweiten Bereich 23 angeordnet, wobei sich die dritte Elektrode von dem zweiten Bereich 23 aus in die erste Richtung entlang der zweiten Achse erstreckt, und die vierte Elektrode sich von dem zweiten Bereich 23 aus in die zweite Richtung entlang der zweiten Achse erstreckt.

Gemäß der ersten Ausführungsform umfasst das Bauteil 1 weiterhin eine fünfte Elektrode 41, die fest mit dem ersten Substrat 11 und/oder mit dem zweiten Substrat 15 verbunden ist und sich von diesem aus in die zweite Richtung entlang der zweiten Achse in das aktive Gebiet 21 erstreckt, wobei die fünfte Elektrode 41 zwischen der ersten Elektrode 221 und der dritten Elektrode 231 angeordnet ist. Des Weiteren kann das Bauteil 1 eine sechste Elektrode 51 aufweisen, die fest mit dem ersten Substrat 11 und/oder mit dem zweiten Substrat 15 verbunden ist und sich von diesem aus in die erste Richtung entlang der zweiten Achse in das aktive Gebiet 21 hinein erstreckt und zwischen der zweiten Elektrode 222 und der vierten Elektrode 232 angeordnet ist. Damit entsprechen die fünfte Elektrode 41 und die sechste Elektrode 51 in gewisser Weise der Elektrode 32 beziehungsweise der Elektrode 33, die in Figur 1B dargestellt waren, wobei die Elektroden gegenüber der in Figur 1B dargestellten Ausführungsform anders ausgeführt und angeordnet sind.

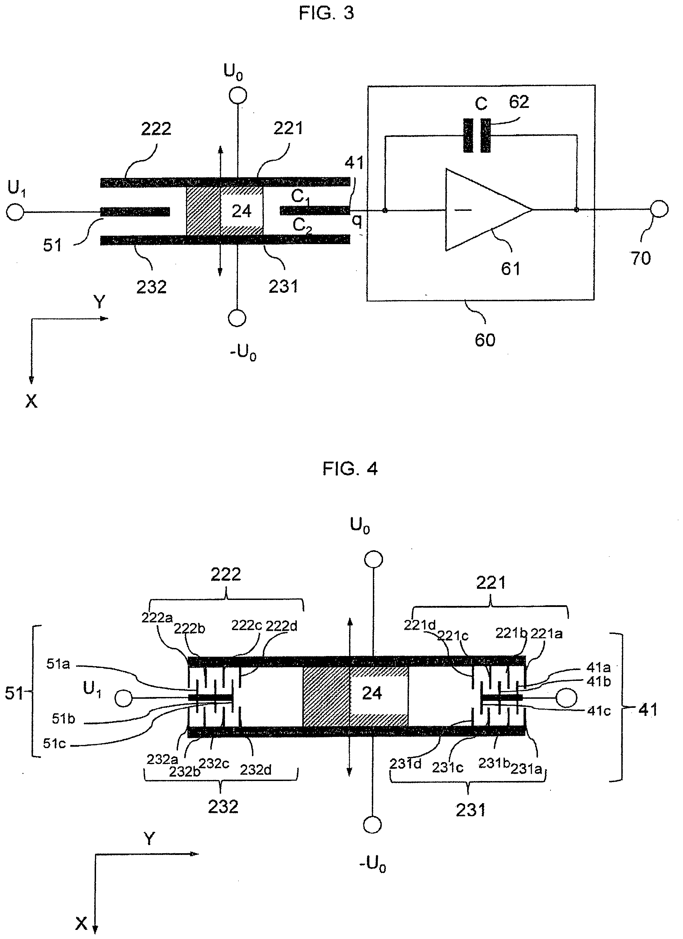

Die Figur 3 zeigt schematisch die in Figur 2 dargestellte Struktur als Elektrodenanordnung sowie die elektrische Belegung der Elektroden in der ersten Ausführungsform des erfindungsgemäßen Bauteils und des erfindungsgemäßen Verfahrens zum Betreiben eines solchen Bauteils. Damit sind in Figur 3 die aktive Struktur 20 sowie die fünfte Elektrode 41 und die sechste Elektrode 51 zu sehen, wobei die aktive Struktur 20 nur durch die erste Elektrode 221, die zweite Elektrode 222, die dritte Elektrode 231 und die vierte Elektrode 232 sowie den isolierenden Bereich 24 dargestellt ist. Die aktive Struktur ist mechanisch gefedert beweglich gelagert, wie dies in Figur 2 dargestellt war, so dass sich die aktive Struktur und damit die erste bis vierte Elektrode 221 bis 232 entlang der ersten Achse, das heißt der X-Achse, bewegen kann, was durch den Pfeil symbolisiert ist. Über die in Figur 2 dargestellten elektrisch leitfähigen Federn 25 und 26 und die dazugehörigen Kontaktbereiche 27 und 28 können an die Elektroden 221 bis 232 definierte Potenziale angelegt werden.

In einer ersten Ausführungsform des Verfahrens zum Betreiben eines Bauteils 1 wird an die erste Elektrode 221 und die zweite Elektrode 222, das heißt an den ersten Bereich 22, eine erste Spannung $U_0$ angelegt, die eine Gleichspannung ist. An die dritte Elektrode 231 und die vierte Elektrode 232, das heißt an den zweiten Bereich 23, wird die negative erste Spannung, das heißt $-U_0$, angelegt. Damit bilden die erste Elektrode 221 und die fünfte Elektrode 41 eine erste Teilkapazität $C_1$, während die dritte Elektrode 231 und die fünfte Elektrode 41 eine zweite Teilkapazität $C_2$ bilden. Die Teilkapazitäten $C_1$ und $C_2$ induzieren eine Ladung Q auf der fünften Elektrode 41, wobei gilt:

$$Q = C_1 \bullet U_0 - C_2 \bullet U_0 = (C_1 - C_2) \bullet U_0 \quad (1).$$

Die fünfte Elektrode 41 ist mit einem Ladungsverstärker 60 verbunden, der einen Operationsverstärker 61 und eine Rückkoppelkapazität 62 umfasst. Der Ladungsverstärker 60 wandelt die auf der fünften Elektrode 41 induzierte Ladung Q in eine Spannung um, die am ersten Ausgang 70 abgegriffen werden kann. Damit dient die fünfte Elektrode 41 als Ausleseelektrode, wobei die ausgelesene Ladung Q proportional zur Differenz $C_1 - C_2$ ist, die ein Maß für die Auslenkung der aktiven Struktur 20 ist, so dass diese Auslenkung gemessen werden kann.

Über die sechste Elektrode 51 kann eine zweite Spannung $U_1$ angelegt werden, wobei diese Spannung $U_1$ eine Antriebs- beziehungsweise Rückstellspannung ist. Die zweite Spannung $U_1$ kann eine Gleichspannung sein, beispielsweise bei Beschleunigungsmessern, oder eine Wechselspannung, beispielsweise bei Kreiseln. Mit Hilfe der zweiten Spannung $U_1$ kann eine Rückstellkraft F auf die aktive Struktur 20 ausgeübt werden, wobei die Rückstellkraft F proportional zur ersten Spannung $U_0$ und zur zweiten Spannung $U_1$ ist. Die Rückstellkraft F berechnet sich wie folgt:

$$F = (U_1 - U_0)^2 - (U_1 + U_0)^2 = 4 \bullet U_1 \bullet U_0 \quad (2).$$

Da die erste Spannung $U_0$ sowohl beim Auslesevorgang gemäß Formel (1) als auch beim Rückstellvorgang gemäß Formel (2) auftritt, kann mit Hilfe der ersten Spannung $U_0$ antriebsseitig eine Modulation und ausleseseitig eine Demodulation durchgeführt werden.

Wenn bei den bisher beschriebenen Bauteilen eintauchende Kämme für die ersten bis sechsten Elektroden 221, 222, 231, 232, 41 und 51 verwendet werden, so dass die Kapazitäten eine lineare Funktion der Auslenkung in X-Richtung sind, ergeben sich keine zusätzlichen auslenkungsabhängigen Kräfte. Solch eine Ausgestaltung der Elektroden ist beispielhaft in Figur 4 dargestellt. Hierbei sind die einzelnen Elektroden jeweils als Kammstruktur ausgebildet, wobei jede Elektrode eine oder mehrere Teilstrukturen umfasst, die sich entlang der X-Richtung erstrecken. Beispielsweise umfasst die erste Elektrode 221 die Teilstrukturen 221a, 221b, 221c und 221d, während die fünfte Elektrode 41 die Teilstrukturen 41a, 41b, 41c und 41d umfasst. Die Teilstrukturen der ersten Elektrode 221 tauchen dabei in die Teilstrukturen der fünften Elektrode 41 ein, so dass sich die Teilstrukturen entlang der X-Achse überlappen. Wenn sich die aktive Struktur des Bauteils entlang der X-Achse bewegt, bewegen sich die Teilstrukturen der ersten Elektrode 221 ebenfalls entlang der X-Achse, so dass sich die Länge der Überlappung der Teilstrukturen der ersten Elektrode 221 mit den Teilstrukturen der fünften Elektrode 41 ändert. Gleiches gilt für die dritte Elektrode 231 bezüglich der fünften Elektrode 41 sowie für die zweite Elektrode 222 und die vierte Elektrode 232 bezüglich der sechsten Elektrode 51. Obwohl jeweils vier Teilstrukturen für alle Elektroden dargestellt sind, ist es auch möglich, dass die Elektroden andere Anzahlen von Teilstrukturen umfassen und/oder dass die Anzahl von Teilstrukturen für verschiedene Elektroden verschieden ist.

Hat man hingegen Kondensatoren mit parallelen, sich annähernden Elektroden, wie in Figur 3 dargestellt, treten in der Auslenkungs-Kapazitäts-Funktion Terme zweiter Ordnung auf, wodurch von der Auslenkung abhängige Kräfte in Form negativer Federkonstanten auftreten. Diese negative elektrostatische Feder wirkt zusätzlich zu den mechanischen ersten und zweiten Feder 25 und 26, die in Figur 2 dargestellt sind. Dieser Effekt ist im Wesentlichen proportional zu den Summen der gewichteten Quadrate der zwischen den Elektroden der betroffenen Kondensatoren liegenden Spannungen. Die Gewichtungen hängen von der Geometrie jedes einzelnen Kondensators ab. Sind die Bauarten gleich, ist die antriebsseitig induzierte Federkonstante im obigen Beispiel proportional zu

$$K = (U_1 - U_0)^2 + (U_1 + U_0)^2 = 2U_1^2 + 2U_0^2 \qquad (3).$$

Dieser Effekt kann zur Abstimmung der Resonanzfrequenz der aktiven Struktur 20 genutzt werden. Jedoch kann dieser Effekt auch unerwünscht sein, da die negative Federkonstante K zu jedem Zeitpunkt von der zweiten Spannung $U_1$ abhängt und daher nur gemeinsam mit der Rückstellkraft und nicht getrennt von dieser eingestellt werden kann.

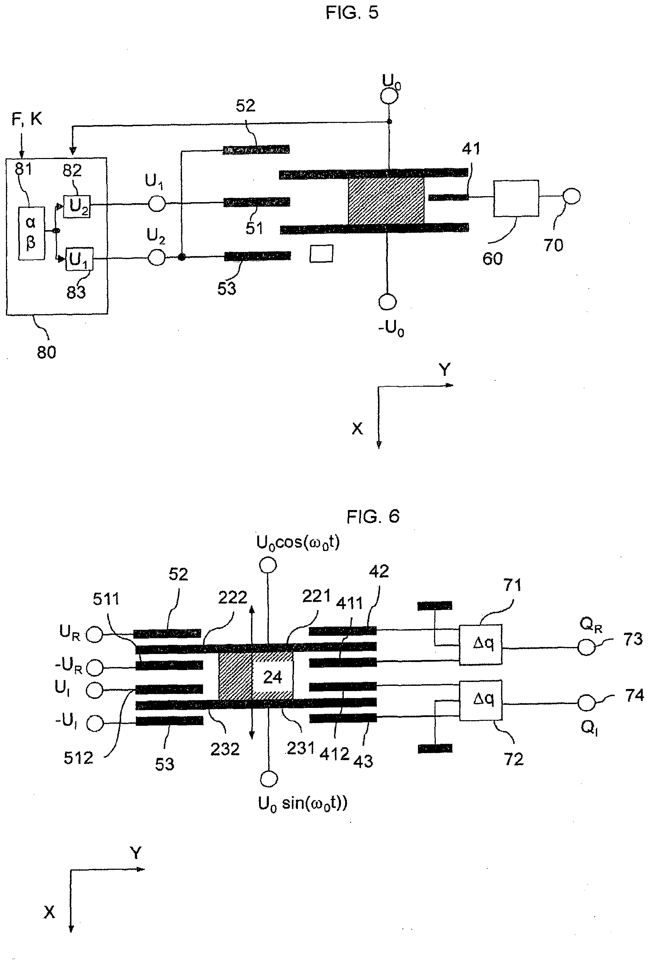

Figur 5 zeigt schematisch eine Elektrodenanordnung und die elektrische Belegung der Elektroden gemäß einer zweiten Ausführungsform des erfindungsgemäßen Bauteils und des erfindungsgemäßen Verfahren zum Betreiben eines solchen Bauteils, mit der dieser negative Effekt beseitigt werden kann.

Die zweite Ausführungsform, die in Figur 4 dargestellt ist, unterscheidet sich von der in Figur 3 dargestellten ersten Ausführungsform des erfindungsgemäßen Bauteils dadurch, dass das Bauteil weiterhin eine siebte Elektrode 52 und eine achte Elektrode 53 umfasst. Die siebte Elektrode 52 und die achte Elektrode 53 sind jeweils fest mit dem ersten Substrat 11 und/oder mit dem zweiten Substrat 15 verbunden und erstrecken sich von diesem aus in das aktive Gebiet 21 hinein in die erste Richtung entlang der zweiten Achse. Das heißt, die siebte Elektrode 52 und die achte Elektrode 53 erstrecken sich in dieselbe Richtung wie die sechste Elektrode 51. Dabei ist die siebte Elektrode so angeordnet, dass die zweite Elektrode 222 zwischen der sechsten Elektrode 51 und der siebten Elektrode 52 angeordnet ist, während die achte Elektrode 53 so angeordnet ist, dass die vierte Elektrode 232 zwischen der sechsten Elektrode 51 und der achten Elektrode 53 angeordnet ist.

Gemäß einer Ausführungsform zum Betreiben des Bauteils in der zweiten Ausführungsform wird an die siebte und die achte Elektrode 52, 53 eine dritte Spannung $U_2$ angelegt, die zur Kompensation der Federkonstanten der ersten Feder 25 und der zweiten Feder 26, mit denen die aktive Struktur 20 beweglich mit dem ersten Substrat 11 und/oder mit dem zweiten Substrat 15 verbunden ist, dient. Die Rückstellkraft F und die antriebsseitig induzierte Federkonstante K, die an dem Bauteil eingestellt werden sollen und damit vorgegeben sind, berechnen sich hier wie folgt:

$$F = 4 \bullet (U_1 - U_2) \bullet U_0 \qquad (4).$$

$$K = 4 \bullet U_0^2 + 2U_1^2 + 2U_2^2 \qquad (5).$$

Damit können die Parameter $\alpha$ und $\beta$ eingeführt werden, für die gilt:

$$\alpha = U_1 - U_2 \qquad (6).$$

$$\beta = U_1 + U_2 \qquad (7).$$

Setzt man die Formeln (6) beziehungsweise (6) und (7) in die Formeln (4) beziehungsweise (5) ein so erhält man:

$$F = 4 \bullet \alpha \bullet U_0 \qquad (8).$$

$$K = 4 \bullet U_0^2 + \alpha^2 + \beta^2 \qquad (9).$$

Damit soll eine Signalverarbeitung, die zur Detektion einer Bewegung der aktiven Struktur 20 oder zur Steuerung der angelegten Antriebs- beziehungsweise Rückstellkraft und der Federkonstanten dient, das heißt zur Steuerung der zweiten Spannung $U_1$ und der dritten Spannung $U_2$, folgende Gleichungen lösen:

$$\alpha = \frac{F}{4 \cdot U_0} \qquad (10).$$

$$\beta = \sqrt{K - 4 \cdot U_0{}^2 - \alpha^2} \qquad (11).$$

$$U_1 = \frac{\alpha + \beta}{2} \qquad (12).$$

$$U_2 = \frac{\beta - \alpha}{2} \qquad (13).$$

Diese Signalverarbeitung kann durch eine Steuereinheit 80 realisiert werden, die in Figur 5 schematisch dargestellt ist. Der Steuereinheit 80 werden von einem Regler oder einer anderen Steuereinheit eines Systems, welches das Bauteil enthält, die einzustellenden Werte für die Rückstellkraft F und die Federkonstante K bereitgestellt. Darüber hinaus wird die erste Spannung $U_0$ der Steuereinheit 80 für die durchzuführenden Berechnungen zur Verfügung gestellt. Die Steuereinheit 80 umfasst eine erste Einheit 81 zur Berechnung der Parameter $\alpha$ und $\beta$ entsprechend der Formeln (10) und (11), eine zweite Einheit 82 zur Berechnung der zweiten Spannung $U_1$ entsprechend der Formel (12) und eine dritte Einheit 83 zur Berechnung der dritten Spannung $U_2$ entsprechend der Formel (13). Die zweite Spannung $U_1$, die an der sechsten Elektrode anliegt, wird entsprechend eines von der zweiten Einheit 82 berechneten Wertes beziehungsweise eines dazu korrespondierenden Signals eingestellt. Die dritte Spannung $U_2$, die an der siebten Elektrode 52 und achten Elektrode 53 anliegt, wird entsprechend eines von der dritten Einheit 83 berechneten Wertes beziehungsweise eines dazu korrespondierenden Signals eingestellt. Damit kann ein Regelkreis zur Steuerung der zweiten Spannung $U_1$ und der dritten Spannung $U_2$ realisiert werden.

Die bisher dargestellten und beschriebenen Ausführungsformen des Verfahrens zum Betreiben eines Bauteils sind dadurch gekennzeichnet, dass an die Elektroden der aktiven Struktur 20 eine Gleichspannung angelegt wurde. Wie bereits beim Stand der Technik beschrieben, kann jedoch auch eine Wechselspannung an die aktive Struktur angelegt werden, wodurch selbstmischende Antriebs- und Auslesefunktionen realisiert werden können. "Selbstmischend" bedeutet, dass bei Kreiseln, die mit einer Arbeitsfrequenz $\omega_0$ (Resonanzfrequenz) arbeiten, durch das Anlegen von Gleichspannungen an den Antriebselektroden eine Rückstellkraft mit der Arbeitsfrequenz $\omega_0$ erzielt werden kann, während eine Auslenkung mit der Arbeitsfrequenz $\omega_0$ Gleichspannungswerte an den Ausleseelektroden beziehungsweise am Ladungsverstärker, das heißt für die Detektion, liefert.

Mit Bezug auf Figur 6, die schematisch eine Elektrodenanordnung und die elektrische Belegung der Elektroden in einer dritten Ausführungsform des erfindungsgemäßen Bauteils und des erfindungsgemäßen Verfahrens zum Betreiben des Bauteils zeigt, soll solch ein Verfahren beschrieben werden. Dabei wird an die erste Elektrode 221 und die zweite Elektrode 222, das heißt an den ersten Bereich 22 der aktiven Struktur 20, eine erste Spannung $U_0 \cdot \cos(\omega_0 \cdot t)$ angelegt, während an den zweiten Bereich 23 der aktiven Struktur 20, das heißt an die dritte Elektrode 231 und die vierte Elektrode 232, eine zeitversetzte zweite Spannung $U_0 \cdot \sin(\omega_0 \cdot t)$ angelegt wird.

Wie in Figur 6 dargestellt ist, weist das Bauteil 1 eine erste fünfte Elektrode 411 und eine zweite fünfte Elektrode 412 auf, die beide zwischen der ersten Elektrode 221 und der dritten Elektrode 231 angeordnet sind und sich ansonsten wie die mit Bezug auf die Figuren 3 und 4 beschriebene fünfte Elektrode 41 erstrecken. Das heißt: die erste fünfte Elektrode 411 und die zweite fünfte Elektrode 412 sind fest mit dem ersten Substrat 11 und/oder dem zweiten Substrat 15 verbunden und erstrecken sich von diesem aus in das aktive Gebiet 21 in eine zweite Richtung entlang der zweiten Achse, das heißt der Y-Achse.

Das Bauteil 1 weist darüber hinaus eine neunte Elektrode 42 und eine zehnte Elektrode 43 auf, die beide jeweils mit dem ersten Substrat 11 und/oder dem zweiten Substrat 15 verbunden sind und sich von diesem aus in die zweite Richtung entlang der zweiten Achse, das heißt der Y-Achse, in das aktive Gebiet 21 erstrecken. Dabei ist die neunte Elektrode 42 so angeordnet, dass die erste Elektrode 221 zwischen der ersten fünften Elektrode 411 und der neunten Elektrode 42 angeordnet ist, während die zehnte Elektrode 43 so angeordnet ist, dass die dritte Elektrode 231 zwischen der zweiten fünften Elektrode 412 und der zehnten Elektrode 43 angeordnet ist.

Das Bauteil 1 umfasst weiterhin eine erste signalverarbeitende Einheit und eine zweite signalverarbeitende Einheit 72. Dabei sind die erste fünfte Elektrode 411 und die neunte Elektrode 42 mit der ersten signalverarbeitenden Einheit 71 verbunden, die eine Ladungsdifferenz zwischen diesen beiden Elektroden bestimmt und eine Ladung $Q_R$ oder eine dazu korrespondierende Spannung an einem ersten Ausgang 73 bereitstellt. Die zweite fünfte Elektrode 412 und die zehnte Elektrode 43 sind mit der zweiten signalverarbeitenden Einheit 72 verbunden, die ebenfalls eine Ladungsdifferenz bestimmt und eine Ladung $Q_I$ beziehungsweise eine dazu korrespondierende Spannung an einem zweiten Ausgang 74 bereitstellt.

Das Bauteil 1 weist weiterhin eine erste sechste Elektrode 511 und eine zweite sechste Elektrode 512 auf, die beide zwischen der zweiten Elektrode 222 und der vierten Elektrode 232 angeordnet sind und sich ansonsten wie die mit Bezug auf die Figuren 3 und 4 beschriebene sechste Elektrode 51 erstrecken. Das heißt, die erste sechste Elektrode 511 und die zweite sechste Elektrode 512 sind fest mit dem ersten Substrat 11 und/oder dem zweiten Substrat 15 verbunden und erstrecken sich von diesem aus in die erste Richtung entlang der zweiten Achse, das heißt der Y-Achse, in das aktive Gebiet 21. Darüber hinaus weist das Bauteil 1 eine siebte Elektrode 52 und eine achte Elektrode 53 auf, wie sie bereits mit Bezug auf die Figur 4 beschrieben worden sind. Damit ist die zweite Elektrode 222 zwischen der ersten sechsten Elektrode 511 und der siebten Elektrode 52 angeordnet, während die vierte Elektrode 232 zwischen der zweiten sechsten Elektrode 512 und der achten Elektrode 53 angeordnet ist.

Gemäß der dritten Ausführungsform des Verfahrens zum Betreiben des Bauteils wird an die siebte Elektrode 52 eine dritte Spannung $U_R$ angelegt, während an die erste sechste Elektrode 511 die negative dritte Spannung - $U_R$ angelegt wird.

An die zweite sechste Elektrode 512 wird eine vierte Spannung $U_I$ angelegt, während an die achte Elektrode 53 die negative vierte Spannung -$U_I$ angelegt wird. Die dritte Spannung $U_R$ und die vierte Spannung $U_I$ sind dabei Gleichspannungen, die jedoch mit einer niedrigen Frequenz periodisch umgepolt werden können.

Damit kann die Kraft, die auf die aktive Struktur 20 wirkt, wie folgt berechnet werden:

$$F = U_R \cdot U_0 \cdot \cos(\omega_0 \cdot t) + U_I \cdot U_0 \cdot \sin(\omega_0 \cdot t) \qquad (14).$$

Die ausgelesenen Ladungen $Q_R$ und $Q_I$ ergeben sich wie folgt:

$$Q_R = \Delta C \cdot U_0 \cdot \cos(\omega_0 \cdot t) \qquad (15),$$

$$Q_I = \Delta C \cdot U_0 \cdot \sin(\omega_0 \cdot t) \qquad (16).$$

Die Kapazitätsdifferenz $\Delta C$, die sich aus der Differenz der Teilkapazitäten C2-C1 ergibt, ist dabei ein Maß für die Auslenkung der aktiven Struktur 20.

Damit können sowohl die Normal- als auch die Quadraturkomponenten antriebsseitig als auch ausleseseitig korrekt verarbeiten werden.

Zum Ausgleich der Drift eines Ladungsverstärkers bei ω=0 können die an der aktiven Struktur 20 angelegten erste Spannung $U_0 \cdot \cos(\omega_0 \cdot t)$ und zweite Spannung $U_0 \cdot \sin(\omega_0 \cdot t)$ sowie die an den Antriebselektroden angelegten dritte Spannung $U_R$ und vierte Spannung $U_I$ mit einer niedrigen Frequenz periodisch umgepolt werden. In diesem Fall werden die ausgelesenen Ladungen $Q_R$ und $Q_I$ im selben Takt demoduliert.

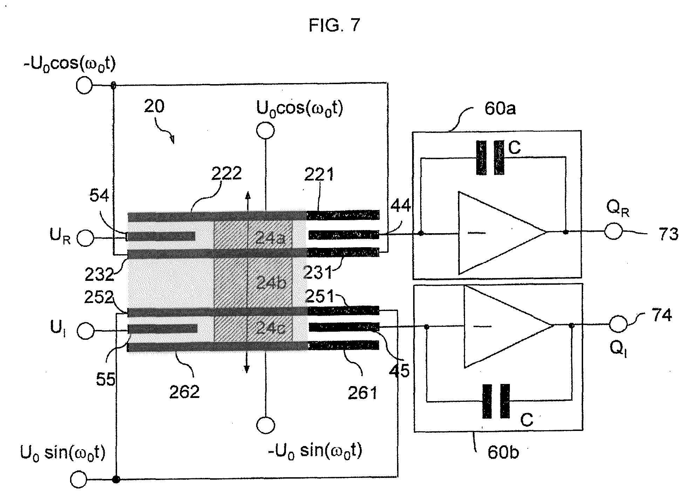

In Figur 7 sind schematisch die Elektrodenanordnungen und elektrischen Belegungen der Elektroden einer weiteren selbstmischenden Variante gemäß einer vierten Ausführungsform des erfindungsgemäßen Bauteils und des erfindungsgemäßen Verfahrens zum Betreiben des Bauteils dargestellt. Dabei weist das Bauteil nicht nur zwei elektrisch leitfähige und entlang der ersten Achse (X-Achse) physisch starr miteinander verbundene, jedoch elektrisch voneinander isolierte Bereiche der aktiven Struktur auf, wie dies in den bisher dargestellten Ausführungsformen der Fall war, sondern vier solcher Bereiche.

Wie in Figur 7 dargestellt, umfasst die aktive Struktur 20 damit einen ersten Bereich 22 mit einer ersten Elektrode 221 und einer zweiten Elektrode 222, einen zweiten Bereich 23 mit einer dritten Elektrode 231 und einer vierten Elektrode 232, einen dritten Bereich 250 mit einer fünften Elektrode 251 und einer sechsten Elektrode 252 sowie einen vierten Bereich 260 mit einer siebten Elektrode 261 und einer achten Elektrode 262. Die einzelnen Bereiche 22, 23, 250 und 260 sind jeweils elektrisch leitfähig und entlang der ersten Achse physisch starr miteinander verbunden. Jedoch sind sie durch isolierende Bereiche 24a, 24b und 24c elektrisch voneinander isoliert. Insbesondere sind der erste Bereich 22 und der zweite Bereich 23 durch einen ersten isolierenden Bereich 24a voneinander isoliert, der zweite Bereich 23 und der dritte Bereich 250 durch einen zweiten isolierenden Bereich 24b voneinander isoliert und der dritte Bereich 250 und der vierte Bereich 260 durch einen dritten isolierenden Bereich 24c voneinander isoliert. Hinsichtlich der isolierenden Bereiche 24a bis 24c gilt das bereits mit Bezug auf Figur 1A Gesagte.

Die erste Elektrode 221 erstreckt sich vom ersten Bereich 22 aus in die erste Richtung entlang der zweiten Achse, das heißt der Y-Achse, während sich die zweite Elektrode 222 jedoch von diesem aus in die zweite Richtung entlang der zweiten Achse erstreckt, wobei die zweite Richtung dabei entgegengesetzt zur ersten Richtung verläuft. Die dritte Elektrode 231 und die vierte Elektrode 232 sind im zweiten Bereich 23 angeordnet, wobei sich die dritte Elektrode von dem zweiten Bereich 23 aus in die erste Richtung entlang der zweiten Achse erstreckt, und die vierte Elektrode sich von dem zweiten Bereich 23 aus in die zweite Richtung entlang der zweiten Achse erstreckt. Die fünfte Elektrode 251 und die sechste Elektrode 252 sind im dritten Bereich 250 angeordnet, wobei sich die fünfte Elektrode von dem dritten Bereich 250 aus in die erste Richtung entlang der zweiten Achse erstreckt, und die sechste Elektrode sich von dem dritten Bereich 250 aus in die zweite Richtung entlang der zweiten Achse erstreckt. Die siebte Elektrode 261 und die achte Elektrode 262 sind im vierten Bereich 260 angeordnet, wobei sich die siebte Elektrode von dem vierten Bereich 260 aus in die erste Richtung entlang der zweiten Achse erstreckt, und die achte Elektrode sich von dem vierten Bereich 260 aus in die zweite Richtung entlang der zweiten Achse erstreckt.

Gemäß der vierten Ausführungsform umfasst das Bauteil weiterhin eine neunte Elektrode 44 und eine zehnte Elektrode 45, die fest mit dem ersten Substrat 11 und/oder mit dem zweiten Substrat 15 verbunden sind und sich von diesem aus in die zweite Richtung entlang der zweiten Achse in das aktive Gebiet 21 erstrecken, wobei die neunte Elektrode 44 zwischen der ersten Elektrode 221 und der dritten Elektrode 231 angeordnet ist und die zehnte Elektrode 45 zwischen der fünften Elektrode 251 und der siebten Elektrode 261 angeordnet ist. Des Weiteren weist das Bauteil eine elfte Elektrode 54 und eine zwölfte Elektrode 55 auf, die fest mit dem ersten Substrat 11 und/oder mit dem zweiten Substrat 15 verbunden sind und sich von diesem aus in die erste Richtung entlang der zweiten Achse in das aktive Gebiet 21 hinein erstrecken, wobei die elfte Elektrode 54 zwischen der zweiten Elektrode 222 und der vierten Elektrode 232 angeordnet ist und die zwölfte Elektrode zwischen der sechsten Elektrode 252 und der achten Elektrode 262 angeordnet ist.

Die aktive Struktur und damit die erste bis achte Elektrode 221 bis 262 können sich entlang der ersten Achse, das heißt der X-Achse, bewegen, was durch den Pfeil symbolisiert ist.

In der vierten Ausführungsform des Verfahrens zum Betreiben eines Bauteils wird an die erste Elektrode 221 und die zweite Elektrode 222, das heißt an den ersten Bereich 22, eine erste Spannung $U_0 \cdot \cos(\omega_0 \cdot t)$ angelegt. An die dritte Elektrode 231 und die vierte Elektrode 232, das heißt an den zweiten Bereich 23, wird die negative erste Spannung, das heißt $-U_0 \cdot \cos(\omega_0 \cdot t)$, angelegt. Damit bilden die erste Elektrode 221 und die neunte Elektrode 44 eine erste Teilkapazität $C_1$, während die dritte Elektrode 231 und die neunte Elektrode 44 eine zweite Teilkapazität $C_2$ bilden. Die Teilkapazitäten $C_1$ und $C_2$ induzieren eine Ladung $Q_R$ auf der neunten Elektrode 44, die mit Hilfe eines einfachen Ladungsverstärkers 60a verstärkt und als Spannung an einem ersten Ausgang 73 ausgelesen werden kann.

An die fünfte Elektrode 251 und die sechste Elektrode 252, das heißt an den dritten Bereich 250, wird eine zeitversetzte zweite Spannung $U_0 \cdot \sin(\omega_0 \cdot t)$ angelegt. An die siebte Elektrode 261 und die achte Elektrode 262, das heißt an den vierten Bereich 260, wird die negative zweite Spannung, das heißt $-U_0 \cdot \sin(\omega_0 \cdot t)$, angelegt. Damit bilden die fünfte Elektrode 251 und die zehnte Elektrode 45 eine dritte Teilkapazität $C_3$, während die siebte Elektrode 271 und die zehnte Elektrode 45 eine vierte Teilkapazität $C_4$ bilden. Die Teilkapazitäten $C_3$ und $C_4$ induzieren eine Ladung $Q_I$ auf der zehnten Elektrode 45, die mit Hilfe eines weiteren einfachen Ladungsverstärkers 60b verstärkt und als Spannung an einem zweiten Ausgang 74 ausgelesen werden kann.

Über die elfte Elektrode 54 kann eine dritte Spannung $U_R$ angelegt werden, während an die zwölfte Elektrode 55 eine vierte Spannung $U_I$ angelegt wird. Die dritte Spannung $U_R$ und die vierte Spannung $U_I$ sind dabei Gleichspannungen, die jedoch mit einer niedrigen Frequenz periodisch umgepolt werden können.

Damit kann die Rückstellkraft F, die auf die aktive Struktur 20 wirkt, ebenfalls nach Formel (14) berechnet werden. Jedoch sind für das Auslesen der Ladungen $Q_R$ und $Q_I$ lediglich einfache Ladungsverstärker 60a und 60b notwendig im Gegensatz zu der in Figur 6 dargestellten dritten Ausführungsform.

Die dargestellten Ausführungsformen des erfindungsgemäßen Bauteils und des erfindungsgemäßen Verfahrens zum Betreiben eines solchen Bauteils ermöglichen die vollständige Trennung der Funktionen für Antrieb und Detektion. Dabei können sowohl nichtmischende Konfigurationen mit jeweils einer Elektrode für den Antrieb und einer Elektrode für die Detektion als auch selbst mischende Konfigurationen mit mehreren Elektroden für den Antrieb und die Detektion realisiert werden. Darüber hinaus kann die negative Federkonstante der Federn 25 und 26, mit der die aktive Struktur 20 mit dem ersten Substrat 11 und/oder dem zweiten Substrat 15 verbunden ist, zur Abstimmung der Resonanzfrequenz der aktiven Struktur 20 genutzt werden. Jedoch ist es auch möglich die Auswirkung der negativen Federkonstante zu beseitigen.

Beim Anlegen einer Gleichspannung an die Elektroden der aktiven Struktur 20 kann eine lineare Spannungskraftfunktion für den Antrieb realisiert werden, wobei schädliche Kapazitäten in der Detektion der Auslenkung der aktiven Struktur 20 unwirksam sind, wodurch eine höhere Genauigkeit der Detektion erzielt werden kann. Werden Mehrfachschwinger, das heißt aktive Strukturen, die aus mehreren, relativ zueinander beweglich gelagerten Strukturen bestehen, verwendet, so können die Antriebs- und Detektionsfunktionen vollständig voneinander getrennt werden, so dass kein Zeitmultiplex notwendig ist. Darüber hinaus ist es möglich, geringe Bandbreiten der Antriebsspannung für den Antrieb und die Ladungssverstärker für die Detektion in Kreiseln, die mit einer Arbeitsfrequenz $\omega_0$ arbeiten, zu verwenden.

**Patentansprüche**

1. Mikromechanisches Bauteil (1), umfassend:

ein Substrat (11, 15),
eine aktive Struktur (20), die bezüglich des Substrates (11, 15) in mindestens eine Richtung auslenkbar ist und die mindestens einen ersten Bereich (22) und einen zweiten Bereich (23) aufweist, wobei der erste Bereich (22) und der zweite Bereich (23) elektrisch leitfähig sind und entlang einer ersten Achse (x) physisch starr miteinander verbunden und durch einen isolierenden Bereich (24) elektrisch voneinander isoliert sind;
eine erste Elektrode (221), die sich von dem ersten Bereich (22) aus in eine erste Richtung entlang einer zweiten Achse (y) erstreckt, und eine zweite Elektrode (222), die sich von dem ersten Bereich (22) aus in eine zweite Richtung entlang der zweiten Achse (y) erstreckt, wobei die zweite Achse (y) senkrecht zur ersten Achse (x) steht und wobei die zweite Richtung entgegengesetzt zur ersten Richtung ist,
eine dritte Elektrode (231), die sich von dem zweiten Bereich (23) aus in die erste Richtung entlang der zweiten Achse (y) erstreckt, und eine vierte Elektrode (232), die sich von dem zweiten Bereich (23) aus in die zweite Richtung entlang der zweiten Achse (y) erstreckt, und
eine fünfte Elektrode (41), die fest mit dem Substrat (11, 15) verbunden ist und sich vom Substrat (11, 15) aus in die zweite Richtung entlang der zweiten Achse (y) erstreckt und zwischen der ersten Elektrode (221) und der dritten Elektrode (231) angeordnet ist.

2. Bauteil nach Anspruch 1, weiterhin umfassend:
eine sechste Elektrode (51), die fest mit dem Substrat (11, 15) verbunden ist und sich vom Substrat (11, 15) aus in die erste Richtung entlang der zweiten Achse (y) erstreckt und zwischen der zweiten Elektrode (222) und der vierten Elektrode (232) angeordnet ist.

3. Bauteil nach Anspruch 2, weiterhin umfassend:

eine siebte Elektrode (52) und
eine achte Elektrode (53),
wobei die siebte Elektrode (52) und die achte Elektrode (53) fest mit dem Substrat (11, 15) verbunden sind und sich vom Substrat (11, 15) aus in die erste Richtung entlang der zweiten Achse (y) erstrecken und
wobei die siebte Elektrode (52) und die achte Elektrode (53) so angeordnet sind, dass die zweite Elektrode (222) zwischen der sechsten Elektrode (51) und der siebten Elektrode (52) angeordnet ist und die vierte Elektrode (232) zwischen der sechsten Elektrode (51) und der achten Elektrode (53) angeordnet ist, wobei
das Bauteil eine Steuereinheit (80) umfasst, die mit der sechsten Elektrode (51), der siebten Elektrode (52) und der achten Elektrode (53) verbunden ist und die geeignet ist, aus einer an dem ersten Bereich (22) angelegten ersten Spannung ($U_0$), einer vorgegebenen Rückstellkraft (F) und einer vorgegebenen Federkonstanten (K) Signale zur Steuerung einer an der sechsten Elektrode (51) angelegten zweiten Spannung ($U_1$) und zur Steuerung einer an der siebten Elektrode (52) und der achten Elektrode (53) angelegten dritten Spannung ($U_2$) zu berechnen; oder
eine erste sechste Elektrode (511) und eine zweite sechste Elektrode (512) zwischen der zweiten Elektrode (222) und der vierten Elektrode (232) angeordnet sind,
wobei die zweite Elektrode (222) zwischen der ersten sechsten Elektrode (511) und der siebten Elektrode (52) angeordnet ist und die vierte Elektrode (232) zwischen der zweiten sechsten Elektrode (512) und der achten Elektrode (53) angeordnet ist.

4. Bauteil nach einem der Ansprüche 2 oder 3,
**dadurch gekennzeichnet, dass**
eine erste fünfte Elektrode (411) und eine zweite fünfte Elektrode (412) zwischen der ersten Elektrode (221) und der dritten Elektrode (231) angeordnet sind,
das Bauteil weiterhin eine neunte Elektrode (42) und eine zehnte Elektrode (43) umfasst, wobei die neunte Elektrode (42) und die zehnte Elektrode (43) fest mit dem Substrat (11, 15) verbunden sind und sich vom Substrat (11, 15) aus in die zweite Richtung entlang der zweiten Achse (y) erstrecken und so angeordnet sind, dass die erste Elektrode (221) zwischen der ersten fünften Elektrode (411) und der neunten Elektrode (42) angeordnet ist und die dritte Elektrode (231) zwischen der zweiten fünften Elektrode (412) und der zehnten Elektrode (43) angeordnet ist; und
die erste fünfte Elektrode (411) und die neunte Elektrode (42) mit einer ersten signalverarbeitenden Einheit (71) verbunden sind; und
die zweite fünfte Elektrode (412) und die zehnte Elektrode (43) mit einer zweiten signalverarbeitenden Einheit (72) verbunden sind.

5.   Bauteil nach Anspruch 1,
     **dadurch gekennzeichnet, dass**
     die aktive Struktur (20) weiterhin einen dritten Bereich (250) und einen vierten Bereich (260) aufweist, wobei der dritte Bereich (250) und der vierte Bereich (260) elektrisch leitfähig sind und entlang der ersten Achse (x) physisch starr miteinander und mit dem ersten Bereich (22) und dem zweiten Bereich (23) verbunden sind, wobei der erste Bereich (22) durch einen ersten isolierenden Bereich (24a) vom zweiten Bereich (23) elektrisch isoliert ist und der dritte Bereich (250) durch einen zweiten isolierenden Bereich (24b) vom zweiten Bereich (23) und durch einen dritten isolierenden Bereich (24c) vom vierten Bereich (260) elektrisch isoliert ist.

6.   Bauteil nach Anspruch 5,
     **dadurch gekennzeichnet, dass**
     eine siebte Elektrode (261) sich von dem vierten Bereich (260) aus in die erste Richtung entlang der zweiten Achse (y) erstreckt, und eine achte Elektrode (262) sich von dem vierten Bereich (260) aus in die zweite Richtung entlang der zweiten Achse (y) erstreckt.

7.   Verfahren zum Betreiben eine mikromechanischen Bauteils (1) gemäß Anspruch 1, umfassend:

     Anlegen einer ersten Spannung $U_0$ an den ersten Bereich (22), wobei die erste Spannung $U_0$ eine Gleichspannung ist, und
     Anlegen der negativen ersten Spannung $-U_0$ an den zweiten Bereich (23).

8.   Verfahren nach Anspruch 7, wobei
     das Verfahren das Bestimmen einer Ladung (q) umfasst, die auf der fünften Elektrode (41) erzeugt wird.

9.   Verfahren nach Anspruch 8,
     **dadurch gekennzeichnet, dass**
     das Bauteil weiterhin eine sechste Elektrode (51), die fest mit dem Substrat (11, 15) verbunden ist und sich vom Substrat (11, 15) aus in die erste Richtung entlang der zweiten Achse (y) erstreckt und zwischen der zweiten Elektrode (222) und der vierten Elektrode (232) angeordnet ist, umfasst;
     an die sechste Elektrode (51) eine zweite Spannung $U_1$ angelegt wird, die eine zu der ersten Spannung $U_0$ und der zweiten Spannung $U_1$ proportionale Kraft auf die aktive Struktur (20) ausübt; das Bauteil weiterhin eine siebte Elektrode (52) und eine achte Elektrode (53) umfasst,

     wobei die siebte Elektrode (52) und die achte Elektrode (53) fest mit dem Substrat (11, 15) verbunden sind und sich vom Substrat (11, 15) aus in die erste Richtung entlang der zweiten Achse (y) erstrecken und
     wobei die siebte Elektrode (52) und die achte Elektrode (53) so angeordnet sind, dass die zweite Elektrode (222) zwischen der sechsten Elektrode (51) und der siebten Elektrode (52) angeordnet ist und die vierte Elektrode (232) zwischen der sechsten Elektrode (51) und der achten Elektrode (53) angeordnet ist;

     an die siebte und die achte Elektrode (52, 53) eine dritte Spannung $U_2$ angelegt wird, die zur Kompensation der Federkonstanten von Federn (25, 26), mit denen die aktive Struktur (20) beweglich mit dem Substrat (11, 15) verbunden ist, dient; und
     die zweite Spannung $U_1$ und die dritte Spannung $U_2$ durch einen Regelkreis gesteuert werden, wobei der Regelkreis eine Steuereinheit (80) umfasst, die aus der ersten Spannung $U_0$, einer vorgegebenen Rückstellkraft (F) und einer vorgegebenen Federkonstanten (K) Signale zur Steuerung der zweiten Spannung $U_1$ und der dritten Spannung $U_2$ berechnet.

10.  Verfahren zum Betreiben eines mikromechanischen Bauteils (1) gemäß Anspruch 1, umfassend:

     Anlegen einer ersten Spannung $U_0 \cdot \cos(\omega_0 t)$ an den ersten Bereich (22), wobei die erste Spannung $U_0$ eine Wechselspannung ist, und
     Anlegen einer zur ersten Spannung $U_0 \cdot \cos(\omega_0 t)$ gleichgroßen, jedoch zeitversetzten zweiten Spannung $U_0 \cdot \sin(\omega_0 t)$ an den zweiten Bereich (23).

11.  Verfahren nach Anspruch 10,
     **dadurch gekennzeichnet, dass**

das Bauteil weiterhin umfasst:

eine erste fünfte Elektrode (411) und eine zweite fünfte Elektrode (412), die fest mit dem Substrat (11, 15) verbunden sind und sich vom Substrat (11, 15) aus in die zweite Richtung entlang der zweiten Achse (y) erstrecken und zwischen der ersten Elektrode (221) und der dritten Elektrode (231) angeordnet sind,

eine erste sechste Elektrode (511) und eine zweite sechste Elektrode (512), die fest mit dem Substrat (11, 15) verbunden sind und sich vom Substrat (11, 15) aus in die erste Richtung entlang der zweiten Achse (y) erstrecken und zwischen der zweiten Elektrode (222) und der vierten Elektrode (232) angeordnet sind,

eine siebte Elektrode (52) und eine achte Elektrode (53), die fest mit dem Substrat (11, 15) verbunden sind und sich vom Substrat (11, 15) aus in die erste Richtung entlang der zweiten Achse (y) erstrecken und so angeordnet sind, dass die zweite Elektrode (222) zwischen der ersten sechsten Elektrode (511) und der siebten Elektrode (52) angeordnet ist und die vierte Elektrode (232) zwischen der zweiten sechsten Elektrode (512) und der achten Elektrode (53) angeordnet ist, und

eine neunte Elektrode (42) und eine zehnte Elektrode (43), die fest mit dem Substrat (11, 15) verbunden sind und sich vom Substrat (11, 15) aus in die zweite Richtung entlang der zweiten Achse (y) erstrecken und so angeordnet sind, dass die erste Elektrode (221) zwischen der ersten fünften Elektrode (411) und der neunten Elektrode (42) angeordnet ist und die dritte Elektrode (231) zwischen der zweiten fünften Elektrode (412) und der zehnten Elektrode (43) angeordnet ist;

an die siebte Elektrode (52) eine dritte Spannung $U_R$ angelegt wird, wobei die dritte Spannung ($U_R$) eine Gleichspannung ist;

an die erste sechste Elektrode (511) die negative dritte Spannung $-U_R$ angelegt wird;

an die zweite sechste Elektrode (512) eine vierte Spannung $U_I$ angelegt wird, wobei die vierte Spannung ($U_I$) eine Gleichspannung ist;

an die achte Elektrode (53) die negative vierte Spannung $-U_I$ angelegt wird; die erste fünfte Elektrode (411) und die neunte Elektrode (42) mit einer ersten signalverarbeitenden Einheit (71) verbunden sind; und

die zweite fünfte Elektrode (412) und die zehnte Elektrode (43) mit einer zweiten signalverarbeitenden Einheit (72) verbunden sind,

wobei in der ersten signalverarbeitenden Einheit (71) und in der zweiten signalverarbeitenden Einheit (72) jeweils eine Ladungsdifferenz ($\Delta Q$) bestimmt wird, die ein Maß für die Auslenkung der aktiven Struktur (20) ist.

12. Verfahren zum Betreiben eine mikromechanischen Bauteils (1) gemäß Anspruch 5, umfassend:

Anlegen einer ersten Spannung $U_0 \cdot \cos(\omega_0 t)$ an den ersten Bereich (22), wobei die erste Spannung $U_0$ eine Wechselspannung ist,

Anlegen der negativen ersten Spannung $-U_0 \cdot \cos(\omega_0 t)$ an den zweiten Bereich (23),

Anlegen einer zur ersten Spannung $U_0 \cdot \cos(\omega_0 t)$ gleichgroßen, jedoch zeitversetzten zweiten Spannung $U_0 \cdot \sin(\omega_0 t)$ an den dritten Bereich (250), und

Anlegen der negativen zweiten Spannung $-U_0 \cdot \sin(\omega_0 t)$ an den vierten Bereich (260).

13. Verfahren nach Anspruch 12,
**dadurch gekennzeichnet, dass**
das Bauteil weiterhin umfasst:

eine sechste Elektrode (251) sich von dem dritten Bereich (250) aus in die erste Richtung entlang der zweiten Achse (y) erstreckt, und eine siebte Elektrode (252) sich von dem dritten Bereich (250) aus in die zweite Richtung entlang der zweiten Achse (y) erstreckt,

eine achte Elektrode (261) sich von dem vierten Bereich (260) aus in die erste Richtung entlang der zweiten Achse (y) erstreckt, und eine neunte Elektrode (262) sich von dem vierten Bereich (260) aus in die zweite Richtung entlang der zweiten Achse (y) erstreckt,

eine zehnte Elektrode (45), die fest mit dem Substrat (11, 15) verbunden ist und sich vom Substrat (11, 15) aus in die zweite Richtung entlang der zweiten Achse (y) erstreckt und zwischen der fünften Elektrode (251) und der siebten Elektrode (261) angeordnet ist,

das Verfahren das Bestimmen einer ersten Ladung ($Q_R$), die auf der neunten Elektrode (44) erzeugt wird, und einer zweiten Ladung ($Q_I$), die auf der zehnten Elektrode (45) erzeugt wird, umfasst.

**14.** Verfahren nach Anspruch 13,
**dadurch gekennzeichnet, dass**

die erste Ladung ($Q_R$) mit einem ersten Ladungsverstärker (60a) bestimmt wird,

die zweite Ladung ($Q_I$) mit einem zweiten Ladungsverstärker (60b) bestimmt wird; und dass
das Bauteil weiterhin umfasst:

eine elfte Elektrode (54), die fest mit dem Substrat (11, 15) verbunden ist und sich vom Substrat (11, 15) aus in die erste Richtung entlang der zweiten Achse (y) erstreckt und zwischen der zweiten Elektrode (222) und der vierten Elektrode (232) angeordnet ist, und
eine zwölfte Elektrode (55), die fest mit dem Substrat (11, 15) verbunden ist und sich vom Substrat (11, 15) aus in die erste Richtung entlang der zweiten Achse (y) erstreckt und zwischen der siebten Elektrode (252) und der neunten Elektrode (262) angeordnet ist;

an die elfte Elektrode (54) eine dritte Spannung $U_R$ angelegt wird, wobei die dritte Spannung $U_R$ eine Gleichspannung ist, und
an die zwölfte Elektrode (55) eine vierte Spannung $U_I$ angelegt wird, wobei die vierte Spannung $U_I$ eine Gleichspannung ist.

**Claims**

**1.** A micromechanical component (1) comprising:

a substrate (11, 15),
an active structure (20), which can be deflected in at least one direction relative to the substrate (11, 15), and which has at least a first region (22) and a second region (23), wherein the first region (22) and the second region (23) are electrically conductive and are rigidly physically connected to one another along a first axis (x) and are electrically insulated from one another by an insulating region (24);
a first electrode (221), which extends outwards from the first region (22) in a first direction along a second axis (y), and a second electrode (222), which extends outwards from the first region (22) in a second direction along the second axis (y), wherein the second axis (y) is perpendicular to the first axis (x), and wherein the second direction is opposite to the first direction, and
a third electrode (231), which extends outwards from the second region (23) in the first direction along the second axis (y), and a fourth electrode (232), which extends outwards from the second region (23) in the second direction along the second axis (y), and
a fifth electrode (41), which is firmly connected to the substrate (11, 15) and extends from the substrate (11, 15) in the second direction along the second axis (y), and is arranged between the first electrode (221) and the third electrode (231).

**2.** The component according to claim 1, further comprising:
a sixth electrode (51), which is firmly connected to the substrate (11, 15), and extends from the substrate (11, 15) in the first direction along the second axis (y) and is arranged between the second electrode (222) and the fourth electrode (232).

**3.** The component according to claim 2, further comprising:

a seventh electrode (52), and
an eighth electrode (53),
wherein the seventh electrode (52) and the eighth electrode (53) are firmly connected to the substrate (11, 15), and extend from the substrate (11, 15) in the first direction along the second axis (y), and
wherein the seventh electrode (52) and the eighth electrode (53) are arranged such that the second electrode (222) is arranged between the sixth electrode (51) and the seventh electrode (52), and the fourth electrode (232) is arranged between the sixth electrode (51) and the eighth electrode (53), wherein
the component comprises a control unit (80), which is connected to the sixth electrode (51), to the seventh electrode (52) and to the eighth electrode (53), and which is suited to calculate, based on a first voltage (U0) applied to the first region (22), a preset resetting force (F) and a preset spring constant (K), signals to control a second voltage (U1) applied to the sixth electrode (51), and to control a third voltage (U2) applied to the seventh electrode (52) and to the eighth electrode (53); or

a first sixth electrode (511) and a second sixth electrode (512) are arranged be-tween the second electrode (222) and the fourth electrode (232),

wherein the second electrode (222) is arranged between the first sixth electrode (511) and the seventh electrode (52), and the fourth electrode (232) is arranged between the second sixth electrode (512) and the eighth electrode (53).

4. The component according to any one of claims 2 or 3,
**characterized in that**
a first fifth electrode (411) and a second fifth electrode (412) are arranged between the first electrode (221) and the third electrode (231),

the component further comprises a ninth electrode (42) and a tenth electrode (43), wherein the ninth electrode (42) and the tenth electrode (43) are firmly connected to the substrate (11, 15) and extend from the substrate (11, 15) in the second direction along the second axis (y) and are arranged such that the first electrode (221) is arranged between the first fifth electrode (411) and the ninth electrode (42), and the third electrode (231) is arranged between the second fifth electrode (412) and the tenth electrode (43); and

the first fifth electrode (411) and the ninth electrode (42) are connected to a first signal-processing unit (71), and the second fifth electrode (412) and the tenth electrode (43) are connected to a second signal-processing unit (72).

5. The component according to claim 1,
**characterized in that**
the active structure (20) further has a third region (250) and a fourth region (260), wherein the third region (250) and the fourth region (260) are electrically conductive and are rigidly physically connected to each other, to the first region (22) and to the second region (23) along the first axis (x), wherein the first region (22) is electrically insulated from the second region (23) by a first insulating region (24a), and the third region (250) is electrically insulated from the second region (23) by a second insulating region (24b) and from the fourth region (260) by a third insulating region (24c).

6. The component according to claim 5,
**characterized in that**
a seventh electrode (261) extends outwards from the fourth region (260) in the first direction along the second axis (y), and an eighth electrode (262) extends outwards from the fourth region (260) in the second direction along the second axis (y).

7. A method for operating a micromechanical component (1) according to claim 1,comprising:

applying a first voltage $U_0$ to the first region (22), wherein the first voltage $U_0$ is a direct voltage, and applying the negative first voltage $-U_0$ to the second region (23).

8. The method according to claim 7, wherein
the method comprises the determination of a charge (q), which is generated on the fifth electrode (41).

9. The method according to claim 8,
**characterized in that**
the component further comprises a sixth electrode (51), which is firmly connected to the substrate (11, 15) and extends from the substrate (11, 15) in the first direction along the second axis (y), and is arranged between the second electrode (222) and the fourth electrode (232); and

a second voltage $U_1$, which exercises a force proportional to the first voltage $U_0$ and to the second voltage $U_1$ on the active structure (20), is applied to the sixth electrode (51);

the component further comprises a seventh electrode (52) and an eighth electrode (53),

wherein the seventh electrode (52) and the eighth electrode (53) are firmly connected to the substrate (11, 15), and extend from the substrate (11, 15)in the first direction along the second axis (y), and

wherein the seventh electrode (52) and the eighth electrode (53) are arranged so that the second electrode (222) is arranged between the sixth electrode (51) and the seventh electrode (52), and the fourth electrode (232) is arranged between the sixth electrode (51) and the eighth electrode (53); and

a third voltage $U_2$ is applied to the seventh and eighth electrodes (52, 53), which serves for compensation of the spring constants of springs (25, 26), by which the active structure (20) is movably connected to the substrate (11, 15); and

the second voltage $U_1$ and the third voltage $U_2$ are controlled by a control circuit, wherein the control circuit comprises a control unit (80), which calculates, based on the first voltage $U_0$, a preset resetting force (F) and a preset spring constant (K), signals to control the second voltage $U_1$ and the third voltage $U_2$.

**10.** A method for operating a micromechanical component (1) according to claim 1, comprising:

applying a first voltage $U_0 \cdot \cos(\omega_0 t)$ to the first region (22), wherein the first voltage $U_0$ is an alternating voltage, and applying a second voltage $U_0 \cdot \sin(\omega_0 t)$, which is equal to the first voltage $U_0 \cdot \cos(\omega_0 t)$, but time-delayed, to the second region (23).

**11.** The method according to claim 10,
**characterized in that**
the component further comprises:

a first fifth electrode (411) and a second fifth electrode (412), which are firmly connected to the substrate (11, 15) and extend from the substrate (11, 15) in the second direction along the second axis (y), and are arranged between the first electrode (221) and the third electrode (231),
a first sixth electrode (511) and a second sixth electrode (512), which are firmly connected to the substrate (11, 15) and extend from the substrate (11, 15) in the first direction along the second axis (y), and are arranged between the second electrode (222) and the fourth electrode (232),
a seventh electrode (52) and an eighth electrode (53), which are firmly connected to the substrate (11, 15) and extend from the substrate (11, 15) in the first direction along the second axis (y) and are arranged such that the second electrode (222) is arranged between the first sixth electrode (511) and the seventh electrode (52), and the fourth electrode (232) is arranged between the second sixth electrode (512) and the eighth electrode (53), and
a ninth electrode (42) and a tenth electrode (43), which are firmly connected to the substrate (11, 15) and extend from the substrate (11, 15) in the second direction along the second axis (y), and are arranged such that the first electrode (221) is arranged between the first fifth electrode (411) and the ninth electrode (42), and the third electrode (231) is arranged between the second fifth electrode (412) and the tenth electrode (43);

a third voltage $U_R$ is applied to the seventh electrode (52), wherein the third voltage $U_R$ is a direct voltage;
the negative third voltage $-U_R$ is applied to the first sixth electrode (511);
a fourth voltage $U_I$ is applied to the second sixth electrode (512), wherein the fourth voltage $U_I$ is a direct voltage;
the negative fourth voltage $-U_I$ is applied to the eighth electrode (53);
the first fifth electrode (411) and the ninth electrode (42) are connected to a first signal-processing unit (71), and the second fifth electrode (412) and the tenth electrode (43) are connected to a second signal-processing unit (72), wherein in the first signal-processing unit (71) and in the second signal-processing unit (72) a charge difference $(\Delta Q)$ is each determined, respectively, which is a measure for the deflection of the active structure (20).

**12.** A method for operating a micromechanical component (1) according to claim 5, comprising:

applying a first voltage $U_0 \cdot \cos(\omega_0 t)$ to the first region (22), wherein the first voltage $U_0$ is an alternating voltage,
applying the negative first voltage $-U_0 \cdot \cos(\omega_0 t)$ to the second region (23),
applying a second voltage $U_0 \cdot \sin(\omega_0 t)$, which is equal to the first voltage $U_0 \cdot \cos(\omega_0 t)$, but time-delayed, to the third region (250), and
applying the negative second voltage $-U_0 \cdot \sin(\omega_0 t)$ to the fourth region (260).

**13.** The method according to claim 12,
**characterized in that**
the component further comprises:

a sixth electrode (251) extends outwards from the third region (250) in the first direction along the second axis (y), and a seventh electrode (252) extends outwards from the third region (250) in the second direction along the second axis (y),
an eighth electrode (261) extends outwards from the fourth region (260) in the first direction along the second axis (y), and a ninth electrode (262) extends outwards from the fourth region (260) in the second direction along the second axis (y),
a tenth electrode (45), which is firmly connected to the substrate (11, 15) and extends from the substrate (11, 15) in the second direction along the second axis (y), and is arranged between the fifth electrode (251) and the seventh electrode (261),

the method comprising determining a first charge (QR), which is generated on the ninth electrode (44), and a second charge ($Q_I$), which is generated on the tenth electrode (45).

14. The method according to claim 13,
**characterized in that**

the first charge ($Q_R$) is determined by a first charge amplifier (60a),

the second charge ($Q_I$) is determined by a second charge amplifier (60b); and that
the component further comprises:

an eleventh electrode (54), which is firmly connected to the substrate (11, 15) and extends from the substrate (11, 15) in the first direction along the second axis (y), and is arranged between the second electrode (222) and the fourth electrode (232), and
a twelfth electrode (55), which is firmly connected to the substrate (11, 15) and extends from the substrate (11, 15) in the first direction along the second axis (y), and is arranged between the seventh electrode (252) and the ninth electrode (262);

a third voltage $U_R$ is applied to the eleventh electrode (54), wherein the third voltage $U_R$ is a direct voltage, and
a fourth voltage $U_I$ is applied to the twelfth electrode (55), wherein the fourth voltage $U_I$ is a direct voltage.

**Revendications**

1. Composant (1) micromécanique comprenant :

un substrat (11, 15),
une structure active (20), qui peut être déviée dans au moins une direction par rapport au substrat (11, 15) et qui présente au moins une première zone (22) et une deuxième zone (23), dans lequel la première zone (22) et la deuxième zone (23) sont conductrices électriquement et sont reliées entre elles de manière rigide physiquement le long d'un premier axe (x) et sont isolées électriquement l'une de l'autre par une zone isolante (24) ;
une première électrode (221), qui s'étend depuis la première zone (22) dans un premier sens le long d'un deuxième axe (y), et une deuxième électrode (222), qui s'étend depuis la première zone (22) dans un deuxième sens le long du deuxième axe (y), dans lequel le deuxième axe (y) est perpendiculaire par rapport au premier axe (x) et dans lequel le deuxième sens est opposé au premier sens,
une troisième électrode (231), qui s'étend depuis la deuxième zone (23) dans le premier sens le long du deuxième axe (y), et une quatrième électrode (232), qui s'étend depuis la deuxième zone (23) dans le deuxième sens le long du deuxième axe (y), et
une cinquième électrode (41), qui est reliée de manière solidaire au substrat (11, 15) et s'étend depuis le substrat (11, 15) dans le deuxième sens le long du deuxième axe (y) et est disposée entre la première électrode (221) et la troisième électrode (231) .

2. Composant selon la revendication 1, comprenant par ailleurs :
une sixième électrode (51), qui est reliée de manière solidaire au substrat (11, 15) et s'étend depuis le substrat (11, 15) dans le premier sens le long du deuxième axe (y) et est disposée entre la deuxième électrode (222) et la quatrième électrode (232) .

3. Composant selon la revendication 2, comprenant par ailleurs :

une septième électrode (52) et
une huitième électrode (53),
dans lequel la septième électrode (52) et la huitième électrode (53) sont reliées de manière solidaire au substrat (11, 15) et s'étendent depuis le substrat (11, 15) dans le premier sens le long du deuxième axe (y), et
dans lequel la septième électrode (52) et la huitième électrode (53) sont disposées de telle sorte que la deuxième électrode (222) est disposée entre la sixième électrode (51) et la septième électrode (52) et la quatrième

**16**

électrode (232) est disposée entre la sixième électrode (51) et la huitième électrode (53), dans lequel le composant comprend une unité de commande (80), qui est reliée à la sixième électrode (51), à la septième électrode (52) et à la huitième électrode (53), et qui est adaptée pour calculer à partir d'une première tension ($U_0$) appliquée à la première zone (22), d'une force de rappel (F) prédéfinie et d'une constante de ressort (K) prédéfinie, des signaux servant à commander une deuxième tension ($U_1$) appliquée à la sixième électrode (51) et servant à commander une troisième tension ($U_2$) appliquée à la septième électrode (52) et de la huitième électrode (53) ; ou

une première sixième électrode (511) et une deuxième sixième électrode (512) sont disposées entre la deuxième électrode (222) et la quatrième électrode (232),

dans lequel la deuxième électrode (222) est disposée entre la première sixième électrode (511) et la septième électrode (52) et la quatrième électrode (232) est disposée entre la deuxième sixième électrode (512) et la huitième électrode (53).

4.  Composant selon l'une des revendications 2 ou 3,
    **caractérisé en ce que**
    une première cinquième électrode (411) et une deuxième cinquième électrode (412) sont disposées entre la première électrode (221) et la troisième électrode (231),
    le composant comprend par ailleurs une neuvième électrode (42) et une dixième électrode (43), dans lequel la neuvième électrode (42) et la dixième électrode (43) sont reliées de manière solidaire au substrat (11, 15) et s'étendent depuis le substrat (11, 15) dans le deuxième sens le long du deuxième axe (y) et sont disposées de telle sorte que la première électrode (221) est disposée entre la première cinquième électrode (411) et la neuvième électrode (42) et la troisième électrode (231) est disposée entre la deuxième cinquième électrode (412) et la dixième électrode (43) ; et
    la première cinquième électrode (411) et la neuvième électrode (42) sont reliées à une première unité de traitement de signaux (71) ; et
    la deuxième cinquième électrode (412) et la dixième électrode (43) sont reliées à une deuxième unité de traitement de signaux (72).

5.  Composant selon la revendication 1,
    **caractérisé en ce que**
    la structure active (20) présente par ailleurs une troisième zone (250) et une quatrième zone (260), dans lequel la troisième zone (250) et la quatrième zone (260) sont conductrices électriquement et sont reliées entre elles de manière rigide physiquement le long du premier axe (x) et à la première zone (22) et la deuxième zone (23), dans lequel la première zone (22) est isolée électriquement de la deuxième zone (23) par une première zone isolante (24a) et la troisième zone (250) est isolée électriquement de la deuxième zone (23) par une deuxième zone isolante (24b) et de la quatrième zone (260) par une troisième zone isolante (24c).

6.  Composant selon la revendication 5,
    **caractérisé en ce que**
    une septième électrode (261) s'étend depuis la quatrième zone (260) dans le premier sens le long du deuxième axe (y), et une huitième électrode (262) s'étend depuis la quatrième zone (260) dans le deuxième sens le long du deuxième axe (y).

7.  Procédé servant à faire fonctionner un composant (1) micromécanique selon la revendication 1, comprenant :

    l'application d'une première tension $U_0$ à la première zone (22), dans lequel la première tension $U_0$ est une tension continue, et
    l'application de la première tension négative $-U_0$ à la deuxième zone (23).

8.  Procédé selon la revendication 7, dans lequel
    le procédé comprend la définition d'une charge (q), qui est générée sur la cinquième électrode (41).

9.  Procédé selon la revendication 8,
    **caractérisé en ce que**
    le composant comprend par ailleurs une sixième électrode (51), qui est reliée de manière solidaire au substrat (11, 15) et s'étend depuis le substrat (11, 15) dans le premier sens le long du deuxième axe (y) et est disposée entre la deuxième électrode (222) et la quatrième électrode (232) ;
    une deuxième tension $U_1$, qui exerce sur la structure active (20) une force proportionnelle à la première tension $U_0$

et à la deuxième tension $U_1$ est appliquée à la sixième électrode (51) ; le composant comprend par ailleurs une septième électrode (52) et une huitième électrode (53),

dans lequel la septième électrode (52) et la huitième électrode (53) sont reliées de manière solidaire au substrat (11, 15) et s'étendent depuis le substrat (11, 15) dans le premier sens le long du deuxième axe (y), et

dans lequel la septième électrode (52) et la huitième électrode (53) sont disposées de telle sorte que la deuxième électrode (222) est disposée entre la sixième électrode (51) et la septième électrode (52) et la quatrième électrode (232) est disposée entre la sixième électrode (51) et la huitième électrode (53) ;

une troisième tension $U_2$, qui sert à la compensation de la constante de ressort de ressorts (25, 26), par lesquels la structure active (20) est reliée de manière mobile au substrat (11, 15), est appliquée à la septième et de la huitième électrode (52, 53) ; et

la deuxième tension $U_1$ et la troisième tension $U_2$ sont commandées par un circuit de régulation, dans lequel le circuit de régulation comprend une unité de commande (80), qui calcule à partir de la première tension $U_0$, d'une force de rappel (F) prédéfinie et d'une constante de ressort (K) prédéfinie, des signaux servant à commander la deuxième tension $U_1$ et la troisième tension $U_2$.

10. Procédé servant à faire fonctionner un composant (1) micromécanique selon la revendication 1, comprenant :

l'application d'une première tension $U_0 \cdot \cos(\omega_0 t)$ à la première zone (22), dans lequel la première tension $U_0$ est une tension alternative, et

l'application d'une deuxième tension $U_0 \cdot \sin(\omega_0 t)$ de même amplitude par rapport à la première tension $U_0 \cdot \cos(\omega_0 t)$, toutefois décalée dans le temps, à la deuxième zone (23).

11. Procédé selon la revendication 10,
**caractérisé en ce que**
le composant comprend par ailleurs :

une première cinquième électrode (411) et une deuxième cinquième électrode (412), qui sont reliées de manière solidaire au substrat (11, 15) et s'étendent depuis le substrat (11, 15) dans le deuxième sens le long du deuxième axe (y) et sont disposées entre la première électrode (221) et la troisième électrode (231),

une première sixième électrode (511) et une deuxième sixième électrode (512), qui sont reliées de manière solidaire au substrat (11, 15) et s'étendent depuis le substrat (11, 15) dans le premier sens le long du deuxième axe (y) et sont disposées entre la deuxième électrode (222) et la quatrième électrode (232),

une septième électrode (52) et une huitième électrode (53), qui sont reliées de manière solidaire au substrat (11, 15) et s'étendent depuis le substrat (11, 15) dans le premier sens le long du deuxième axe (y) et sont disposées de telle sorte que la deuxième électrode (222) est disposée entre la première sixième électrode (511) et la septième électrode (52) et la quatrième électrode (232) est disposée entre la deuxième sixième électrode (512) et la huitième électrode (53), et

une neuvième électrode (42) et une dixième électrode (43), qui sont reliées de manière solidaire au substrat (11, 15) et s'étendent depuis le substrat (11, 15) dans le deuxième sens le long du deuxième axe (y) et sont disposées de telle sorte que la première électrode (221) est disposée entre la première cinquième électrode (411) et la neuvième électrode (42) et la troisième électrode (231) est disposée entre la deuxième cinquième électrode (412) et la dixième électrode (43) ;

une troisième tension $U_R$ est appliquée à la septième électrode (52), dans lequel la troisième tension ($U_R$) est une tension continue ;

la troisième tension négative $-U_R$ est appliquée à la première sixième électrode (511) ;

une quatrième tension $U_1$ est appliquée à la deuxième sixième électrode (512), dans lequel la quatrième tension ($U_1$) est une tension continue ;

la quatrième tension négative $-U_1$ est appliquée à la huitième électrode (53) ;

la première cinquième électrode (411) et la neuvième électrode (42) sont reliées à une première unité de traitement de signaux (71) ; et

la deuxième cinquième électrode (412) et la dixième électrode (43) sont reliées à une deuxième unité de traitement de signaux (72),

dans lequel respectivement une différence de charge ($\Delta Q$), qui est une mesure pour la déviation de la structure active (20), est définie dans la première unité de traitement de signaux (71) et dans la deuxième unité de traitement de signaux (72).

12. Procédé servant à faire fonctionner un composant (1) micromécanique selon la revendication 5, comprenant :

l'application d'une première tension $U_0 \cdot \cos(\omega_0 t)$ à la première zone (22), dans lequel la première tension $U_0$ est une tension alternative,

l'application de la première tension négative $- U_0 \cdot \cos(\omega_0 t)$ à la deuxième zone (23),

l'application d'une deuxième tension $U_0 \cdot \sin(\omega_0 t)$ de même taille par rapport à la première tension $U_0 \cdot \cos(\omega_0 t)$, toutefois décalée dans le temps, à la troisième zone (250), et

l'application de la deuxième tension négative $- U_0 \cdot \sin(\omega_0 t)$ à la quatrième zone (260).

13. Procédé selon la revendication 12,
**caractérisé en ce que**
le composant comprend par ailleurs :

une sixième électrode (251), qui s'étend depuis la troisième zone (250) dans le premier sens le long du deuxième axe (y), et une septième électrode (252), qui s'étend depuis la troisième zone (250) dans le deuxième sens le long du deuxième axe (y),

une huitième électrode (261), qui s'étend depuis la quatrième zone (260) dans le premier sens le long du deuxième axe (y), et une neuvième électrode (262), qui s'étend depuis la quatrième zone (260) dans le deuxième sens le long du deuxième axe (y),

une dixième électrode (45), qui est reliée de manière solidaire au substrat (11, 15) et s'étend depuis le substrat (11, 15) dans le deuxième sens le long du deuxième axe (y) et est disposée entre la cinquième électrode (251) et la septième électrode (261),

le procédé comprend la définition d'une première charge ($Q_R$), qui est générée sur la neuvième électrode (44), et d'une deuxième charge ($Q_1$), qui est générée sur la dixième électrode (45).

14. Procédé selon la revendication 13,
**caractérisé en ce que**
la première charge ($Q_R$) est définie avec un premier amplificateur de charge (60a),
la deuxième charge ($Q_1$) est définie avec un deuxième amplificateur de charge (60b) ; et que
le composant comprend par ailleurs :

une onzième électrode (54), qui est reliée de manière solidaire au substrat (11, 15) et s'étend depuis le substrat (11, 15) dans le premier sens le long du deuxième axe (y) et est disposée entre la deuxième électrode (222) et la quatrième électrode (232), et

une douzième électrode (55), qui est reliée de manière solidaire au substrat (11, 15) et s'étend depuis le substrat (11, 15) dans le premier sens le long du deuxième axe (y) et est disposée entre la septième électrode (252) et la neuvième électrode (262) ;

une troisième tension $U_R$ est appliquée à la onzième électrode (54), dans lequel la troisième tension $U_R$ est une tension continue, et

une quatrième tension $U_1$ est appliquée à la douzième électrode (55), dans lequel la quatrième tension $U_1$ est une tension continue.

## FIG. 1A

## FIG. 1B

FIG. 2

EP 3 110 746 B1

FIG. 3

FIG. 4

## FIG. 5

## FIG. 6

FIG. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2010134860 A1
- US 6078016 A
- US 2010117166 A1
- US 6067858 A
- US 6291875 B1